Europäisches Patentamt

European Patent Office

Office européen des brevets

(11) Publication number: **0 249 762 B1**

# EUROPEAN PATENT SPECIFICATION

(45) Date of publication of patent specification: **08.05.91**   (51) Int. Cl.⁵: **H01L 23/00**

(21) Application number: **87107307.8**

(22) Date of filing: **20.05.87**

The file contains technical information submitted
after the application was filed and not included in
this specification

(54) **Identifying semiconductor wafers with bar code patterns thereon.**

(30) Priority: **20.05.86 JP 116422/86**
**18.06.86 JP 142533/86**

(43) Date of publication of application:
**23.12.87 Bulletin 87/52**

(45) Publication of the grant of the patent:
**08.05.91 Bulletin 91/19**

(84) Designated Contracting States:
**DE FR GB**

(56) References cited:
**DE-A- 3 138 085**
**US-A- 4 292 576**
**US-A- 4 585 931**

**PATENT ABSTRACTS OF JAPAN, vol. 10, no.
197 (E-418)[2253], 10th July 1986; & JP-A-61
42 119 (NIPPON KOGAKU K.K.) 28-02-1986**

**PATENT ABSTRACTS OF JAPAN, vol. 7, no.
58 (E-163)[1203], 10th March 1983; & JP-A-57
206 042 (FUJITSU K.K.) 17-12-1982**

(73) Proprietor: **FUJITSU LIMITED**
**1015, Kamikodanaka Nakahara-ku**
**Kawasaki-shi Kanagawa 211(JP)**

(72) Inventor: **Kiriseko, Tadashi Fujitsu Ltd. Patent
Dept.**
**Kosugi Fujitsu Building 1812-10**
**Shimonumabe**
**Nakahara-ku Kawasaki-shi Kanagawa 211(JP)**
Inventor: **Iijima, Nobuo Fujitsu Ltd. Patent
Dept.**
**Kosugi Fujitsu Building 1812-10**
**Shimonumabe**
**Nakahara-ku Kawasaki-shi Kanagawa 211(JP)**

(74) Representative: **Sunderland, James Harry et al
HASELTINE LAKE & CO Hazlitt House 28
Southampton Buildings Chancery Lane
London WC2A 1AT(GB)**

SOLID STATE TECHNOLOGY, vol. 22, no. 6, June 1979, pages 77-79, Port Washington, New York, US; B.I.C.F. VAN PUL: "Coding and decoding of wafers"

PATENT ABSTRACTS OF JAPAN, vol. 8, no. 115 (E-247)[1552], 29th May 1984; & JP-A-59 29 433 (HITACHI SEISAKUSHO K.K.) 16-02-1984

IBM TECHNICAL DISCLOSURE BULLETIN, vol. 25, no. 1, June 1982, pages 319-322, Armonk, New York, US; D.A. NIELSEN et al.: "Laser-written and -read symbol set of high radix"

## Description

The present invention relates to a method of identifying semiconductor wafers utilizing bar code patterns formed thereon.

When semiconductor wafers are planned for fabrication of gate array integrated circuits, the bulk wafer processes employed (the steps prior to a first metallization process) are the same for all wafers. However, because such wafers are thereafter subjected to different metal layer patterning processes depending on the logic circuit designs to be implemented, it is required that a code pattern for each logic circuit to be implemented is formed at a time just before a patterning process is carried out in relation to the first metallization.

Generally, identification of individual wafers is not necessary when usual processes for forming integrated circuits are carried out. This is because many wafers in one lot, which are usually carried in the same wafer carrier, are subject to the same processes, and lot identification of wafers is sufficient to provide identification for ensuring that the correct processes are applied to the wafers. However, considering metallization processes for forming gate array integrated circuits, the production quantity of circuits using the same metal pattern is likely to be extremely limited. Therefore, it is necessary that each wafer should be individually identified in every step on and after the first metal patterning process to ensure that correct processes are applied to each wafer.

With progress in automation of production, use of bar code patterns for identification is more practical, because they are suitable for automatic recognition utilizing a bar code reader. One method of forming a bar code pattern for identification of an individual wafer is to utilize a photolithography technique for patterning a metal layer, which is separately patterned to meet the specific requirements of identification.

The bar code pattern thus formed in the metal layer is subsequently subjected to processes for formation of an insulating layer, a second metallization when required, a passivation layer, and the like. Previously, for each such process, wafer identification has been effected using a method in which light is applied to the surface of the wafer from the front side thereof, reflected light is received, and the bar code pattern detected.

If the bar code pattern is formed on the wafer surface itself, the problems of recognition of the pattern are more serious. Because deposited layers on the bar code pattern have different reflection factors and flat surfaces, causing multiple reflection of the light used for detection, it is difficult to get a clear and distinct detection signal from the bar code pattern. Furthermore, the bar code pattern is liable to be damaged during wafer production processes so that the bar code may be incorrectly identified. It sometimes becomes impossible to decode any signal. Even in a case in which the naked eye can recognize the code pattern, automatic identification may be impossible.

JP-A-61 42119 (and Patent Abstracts of Japan, Vol. 10, No. 197 (E-418)(2253), 10 July 1986) discloses a method for recognising a bar code on a wafer, involving detection of reflected light diffracted by the bar code pattern which is of a form adapted to provide diffraction of reflected light.

US-A-4 585 931 discloses a method for recognising a bar code on a wafer, involving detection of light reflected from the bar code pattern which is of a "stretched" form, with a selected aspect ratio. The bar code pattern is produced by laser marking on a surface of the wafer.

JP-A-57 206042 (and Patent Abstracts of Japan, Vol. 7, No. 58, (E-163)(1203), 10 March 1983) discloses a method for checking wiring patterns of a wafer, in which infrared light is transmitted through the wafer (but is reflected by metal on the wafer) where metallic wiring patterns are located. Light from two patterns is sensed and the results compared. If there is a difference it is determined that one of the patterns is defective.

According to the present invention there is provided a method for identifying a semiconductor wafer utilising a bar code pattern formed thereon, said method comprising:-

applying light, including infrared light, to a first side of the semi conductor wafer;

receiving infrared light transmitted through said semi conductor wafer, at a second side of said semi conductor wafer; and

identifying the semiconductor wafer by decoding the received light.

An embodiment of the present invention can provide a method of identifying a semiconductor wafer in an easier way, With good accuracy, even when a code pattern is covered with a plurality of insulating layers.

An embodiment of the present invention can provide a method of identifying automatically a semiconductor wafer without the help of human visual perception.

An embodiment of the present invention can provide a method of forming a bar code pattern in an easier and simpler way.

Previously, incident light has been applied to the front surface of a semiconductor wafer, and reflected light front wafer received by a detector. In this case, the received reflected light from the bar code pattern are a includes random reflected light from deposited layers formed thereon.

In accordance with an embodiment of the present invention, a light source is provided at the back side of the wafer and transmitted light is received and detected at the front side thereof. This arrangement largely eliminates random reflected light as experienced in the previous method. The use of a light source providing infrared rays is suitable for this purpose, because a silicon wafer can easily transmit infrared rays.

When using light transmitted through a silicon wafer in this way, the bar code pattern is desirably formed in a metal layer which effectively interrupts transmission of light except in areas where metal has been removed.

As the metal layer for marking the bar code pattern (in which the pattern is formed), a first metal layer (usually an aluminum layer) for connection of active elements in a chip area can be used. Though the bar code pattern can be formed by a photolithography technique, in the case of gate array integrated circuits it should be formed before a photolithography process for forming the wiring pattern of the first metal layer is carried out, because identification of the wafer is necessary before the photolithography process for patterning the first metal layer is carried out. Therefore a separate photolithography process is needed for forming the bar code pattern.

In an embodiment of the present invention, the bar code pattern is formed by scribing a wiring layer, e.g. the first, alumininm layer, by a laser beam, melting and evaporating the alumininum of the scribed area. This method eliminates a photolithography process for forming the bar code pattern and is very useful to save time.

In an embodiment of the present invention the light source and the detecting means may be arranged with positions reversed from those mentioned above. Further, the bar code pattern can be formed on silicon wafer itself, not using the metal layer.

An embodiment of this invention can provide that better contrast is obtained in detection of a bar code pattern, and is especially suitable for use in relation to fabrication processes applied to semi conductor wafers for which different metal pattern processes (for forming integrated circuits) are required to be carried out after bulk processes, the same for all wafers, are finished.

Reference is made by way of example, to the accompanying drawings, in which:-

Fig. 1 is a schematic drawing of an apparatus, for assistance in explaining a method of identifying a semi conductor wafer according to an embodiment of the present invention,

Fig. 2 is a schematic top view of a stage used in the apparatus of Fig. 1,

Fig. 3 is a graph illustrating a relationship between incident light wavelength and a percent transmission through a silicon wafer,

Fig. 4 is a schematic block flow diagram illustrating manufacturing processes applied to a wafer after bulk wafer processes,

Figs. 5 to 11 are respective schematic cross sectional views of a wafer corresponding to respective successive manufacturing steps after bulk wafer processes, whereby each Figure illustrates the structures of a chip area and of a bar code pattern area,

Fig. 12 illustrates a method of forming a bar code pattern directly cn silicon wafer, which can be employed in relation to an embodiment of the present invention, and

Fig. 13 illustrates another arrangement of a light source and a detecting means which can be employed in relation to an embodiment of the present invention.

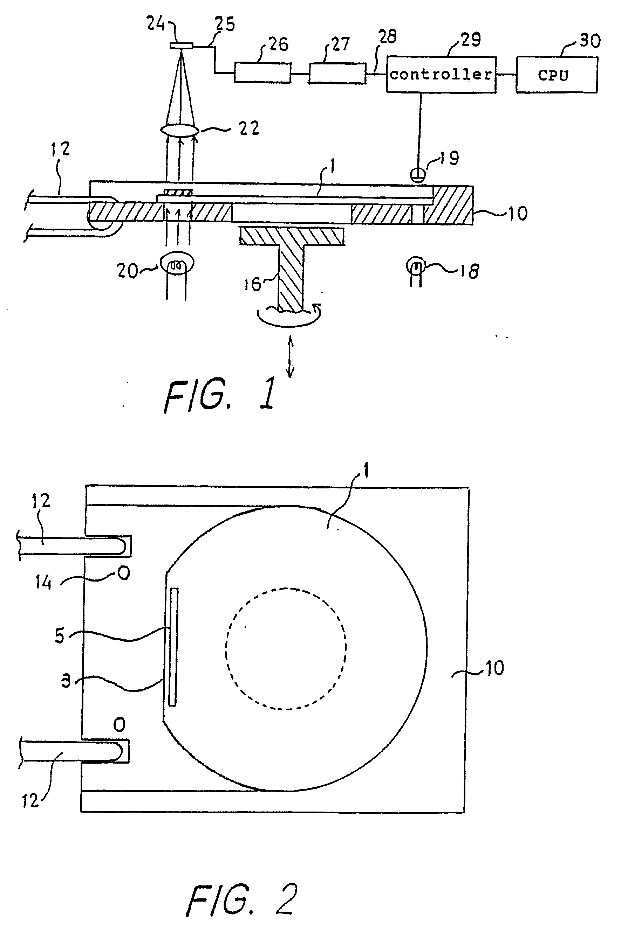

Fig.1 schematically illustrates apparatus for assistance in explaining a method of identifying a semiconductor wafer in an embodiment of the present invention, and Fig. 2 shows a top view of a stage 10 of the apparatus loaded with a semiconductor wafer 1.

In Figs. 1 and 2, silicon semiconductor wafer 1 is transported on conveyor belt 12 from the left side of Fig. 1, and is moved to a seating position with the aid of an air stream from an orifice 14. Then a rotary positioner 16 is raised upwards and rotated around its axis, as indicated by arrowed lines. Photodiode 18 and sensor 19 detect the position of an orientation flat 3, and when semiconductor wafer 1 is further rotated to a position as shown in Fig. 2, rotation of positioner 16 is halted and the positioner is lowered, under control of a controller 29.

Light source 20, which provides infrared rays, irradiates the back side of semiconductor wafer 1. As the light source 20, a tungsten heater lamp which generates both visible and infrared rays, a helium-neon gas laser which includes abundant 3.39 $\mu$m infrared rays, and many other kinds of semiconductor LEDs and lasers can be used.

Light penetrating through semiconductor wafer 1 and a bar code pattern 5 formed thereon is received by an image sensor which comprises a lens system 22 and a CCD (charge-coupled-device) detector 24. For the purpose of a embodiment of the present invention, a one dimensional CCD sensor having a 2048 bit resolution is practical and useful.

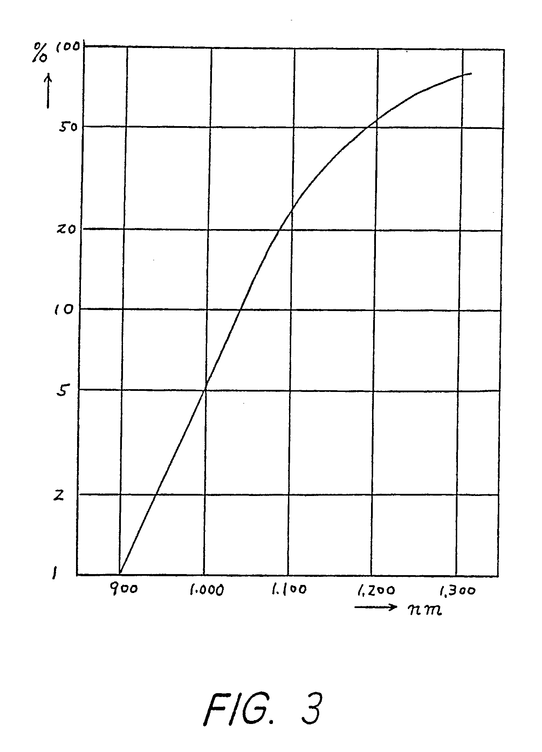

Silicon wafers of a thickness conventionally used (for example, 600 $\mu$m thickness) are transparent for infrared rays. One example of the relationship between incident light wavelength and a percent transmission through the wafer is shown in Fig. 3. Above a wavelength of about 1,300 nm (1.3 $\mu$m), most of incident rays are transmitted through the wafer (except in areas covered by metal layer parts by which the bar code pattern is formed).

In Fig. 1, a signal 25 detected by CCD detector 24 is input to a waveform shaper 26 and then to a converter 27 for providing a binary signal 28. The binary signal 28 from the converter 27, which corresponds with the bar code pattern marked on the wafer 1, is input to controller 29, in which the semiconductor wafer 1 is identified. CPU 30 connected to controller 29 gives further instructions concerning subsequent processes to be applied to the wafer 1.

In production of integrated circuits, a master slice procedure is generally utilized especially for gate array integrated circuits, in which logic gates such as NANDs, NORs and the like are arranged in arrays on a wafer. With such a gate array process, all common bulk wafer processes before the patterning of the first metal layer can be completed (in advance of receipt of a customer's specifications) and the resultant semi-finalized wafers can be stored.

On receiving a customer's specification for finished devices, a specific mask for metal patterning is prepared. In production, stored wafers are subjected selectively to specific photolithography processes to satisfy the customer's specification. Therefore the master slice procedure necessitates a variety of mask pattern processes, but a quantity of wafers in a production lot may be small.

With the master slice procedure mentioned above it is necessary that a new code number be given to a wafer on which a first metal layer has been already deposited, in order to identify the wafer so that it is subsequently subjected to the correct individual mask and etching processes for providing different metal patterns.

In other words, throughout the bulk wafer processes every wafer is subject to the same processes. On the other hand, for and after the mask process of patterning the (first) metal layer, each wafer should be identified individually so that different processes can be correctly applied to the individual wafers. Therefore, it is desirable to form a bar code pattern on the wafer after completion of the bulk wafer process but before patterning of the (first) metal layer.

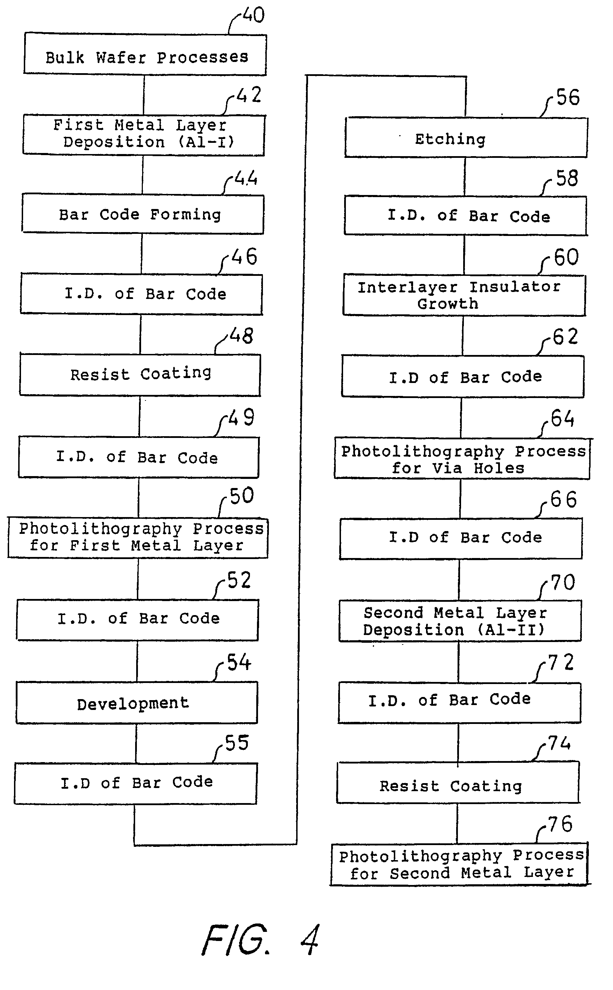

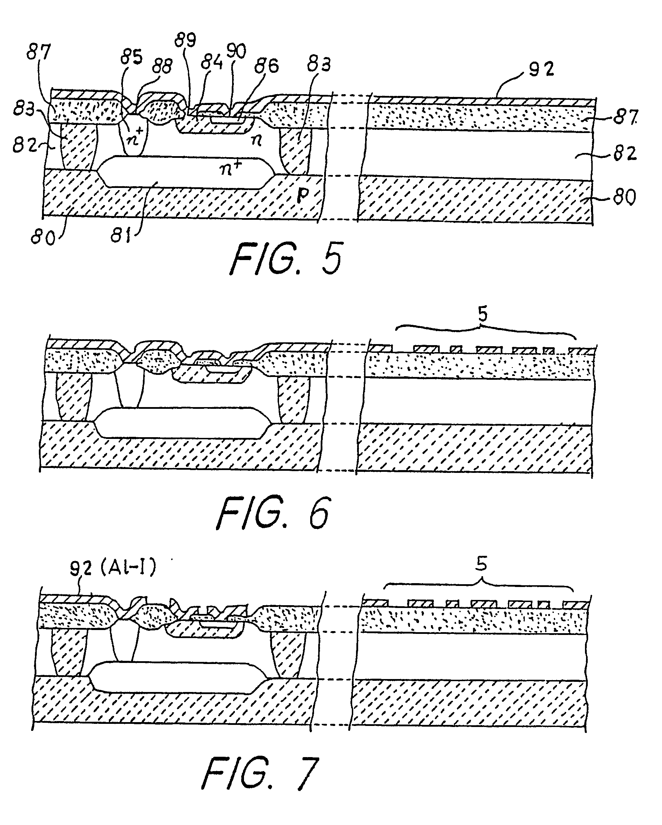

Fig.4 is a block diagram illustrating the process flow involved in a master slice procedure. Figs. 5 to 11 give partial cross sectional views of a wafer at stages corresponding to specific steps in the process flow of Fig. 4. With regard to Figs. 5 to 11, the left side of each Figure shows a chip area, and the right side shows a bar code pattern area near the orientation flat edge of a wafer. In the chip area, for the purposes of illustration, only one bipolar transistor is shown, as a typical active element.

In the following explanations, both Fig. 4 and Figs. 5 to 11 will be referred to.

In Fig. 4, all bulk processes before a (first) metal deposition process are briefly represented as step 40. When step 42, the step of depositing a metal layer 92 (usually an aluminum layer is employed) is finished, the wafer structure shown in Fig. 5 is obtained.

During the bulk wafer processes, as indicated by Fig. 5, p-type silicon substrate 80 is used, and $n^+$ buried layer 81 is formed therein. Then n-type epitaxial layer 82 is grown thereon. Next, silicon dioxide 87 (field oxide film) is formed thereon, and then $p^+$ isolation 83 is formed by implanting boron ions. Next, $n^+$ collector contact 85, p-type base region 84 and n-type emitter region 86 are formed in succession by implanting phosphorus or boron impurity ions. Then, contact openings 88, 89, 90 are formed in silicon dioxide layer 87 in preparation for step 42 - the first metallization process (Al-I layer). The structure on the left of Fig. 5 illustrates a popular bipolar transistor. The bulk processes for forming such a structure are well known and therefore detailed explanations are omitted.

During the bulk wafer processes 40, the surface or region near the orientation flat edge of the wafer is subjected to the same processes as the chip area, except for impurity diffusion. Thus, n-type epitaxial layer 82 and silicon dioxide layer 87 are formed on p-type silicon substrate 80 in the region near the orientation flat edge (on the right in Fig. 5)

For production of a gate array integrated circuit having specific metal patterning, the bar code pattern is first formed on the wafer, which is indicated as step 44 in Fig. 4. Previously, a bar code pattern on a wafer has been formed by a photolithography technique. The photolithography technique can provide a fine pattern consisting of a sequence of stripes having widths of 100 to 250 $\mu$m. However, the photolithography process involved requires an additional mask process and a considerable amount of lead time.

Recently, remarkable progress in the accuracy of laser scribers has been made. It has been found that a bar code pattern can be formed by a laser scribing method. For an embodiment of the present invention, a laser scriber which can form a bar code pattern having a width of 100 $\mu$m can be used. When the laser beam spot sweeps over the aluminum layer 92 in Fig. 5, the aluminum can easily be melted and evaporated to form bar code pattern 5 in Fig. 6.

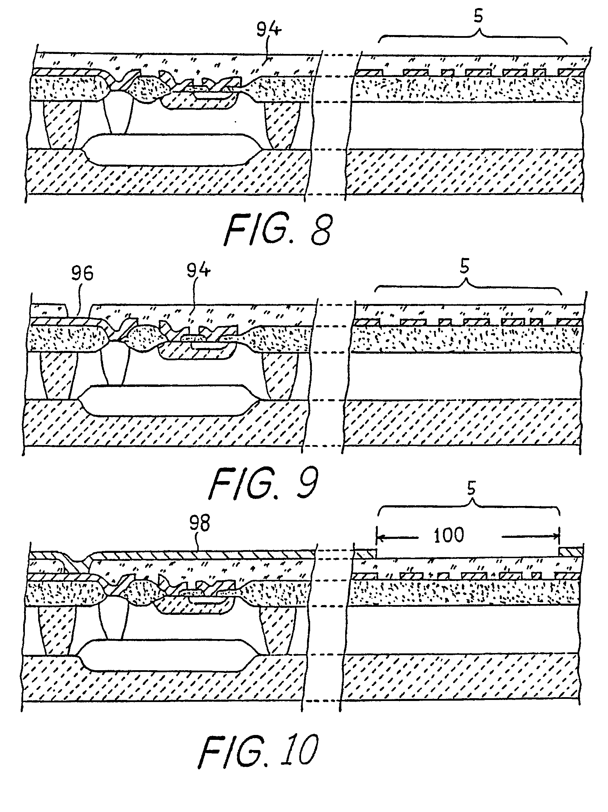

After forming the bar code pattern consisting of a specific type number, a lot number and the like, the wafer is subjected to a process for patterning the first aluminum layer, called Al-I. This process consists of a series of process steps: resist coating 48, a photolithography process 50 including selection of a specific mask and exposure processes, development 54, and etching 56, and these steps are shown in Fig. 4. However, these steps should be preceded by identification steps 46, 49, 52 and 55, for identifying the wafer by detecting the bar code 5 because different wafers are expected to have different types of metal patterning, and are flowing mixed in the same production line. Such detection of the bar code 5 is performed as explained in Figs. 1 and 2. When Al-I is formed (when the first metal layer has been patterned), the structure is shown in Fig. 7.

Next, interlayer insulator 94 is grown on an entire surface (step 60), as shown in Fig. 8. As the material of interlayer insulator 94, silicon dioxide, phospho-silicate-glass (PSG), or silicon nitride can be used.

Next, via holes 96 for multilevel interconnection are formed in interlayer insulator 94 as shown in Fig. 9. In this process, an identification step 62, for identifying the wafer, and another photolithography process (step 64) are needed, and step 64 also comprises steps of resist coating, another identification of the wafer, mask selection, exposure, development, and etching. These steps are briefly put together and represented as single step 64.

Next follows step 70 involving formation of a second metal (aluminum) layer 98 as indicated in Figs. 4 and 10. In this process a window 100 should be formed in the metal layer 98, such that the metal layer 98 does not disturb the transmission of light through the wafer around the bar code pattern area.

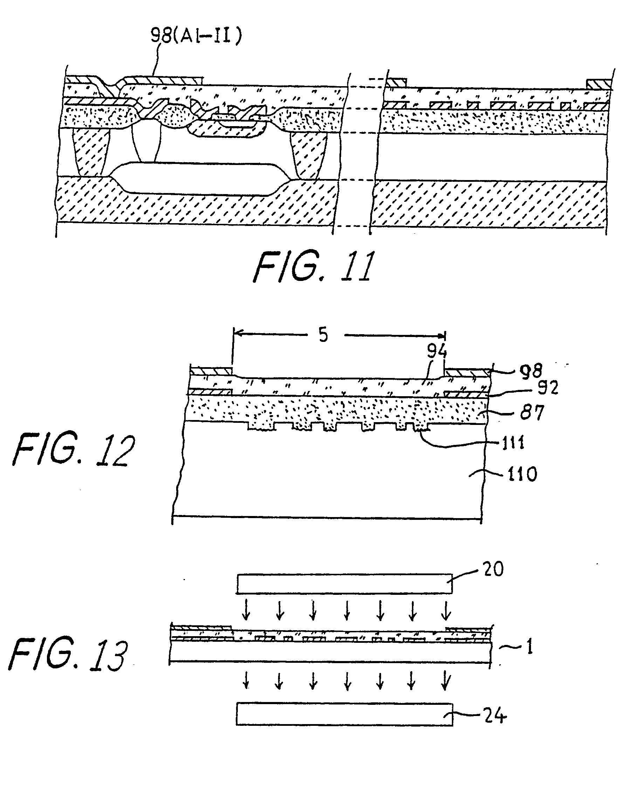

Finally, identification step 72, using the transmission of infrared rays through the wafer substrate at the bar code pattern 5, resist coating step 74 and photolithography step 76 and subsequent steps (the details are just the same as steps 52 through 56 explained in forming Al-I, and are omitted in Fig. 4) are followed. As a result, the second aluminum layer is patterned forming Al-II, which is shown in Fig. 11.

In the foregoing embodiment, the bar code pattern 5 is formed in the first metal (aluminum) layer 92, because the aluminum metal layer is the best material for interrupting the transmission of light.

Our experiments also show that a bar code pattern formed on the silicon surface can sufficiently reduce the transmission of infrared rays. As illustrated in Fig. 12, a bar code pattern which is scribed on the surface of silicon wafer 110 by a laser beam and is worked to have a rough surface 111 can be used for identification of wafers. Therefore, an embodiment of the present invention can be applied for identifying a bar code pattern which is directly formed on the silicon wafer 110 by laser scribing. In this case, a window is formed for all metal layers 92, 98 deposited on the bar code pattern area 5 such as the opening window 100 shown in Fig. 10.

Moreover, as indicated in Fig. 13, the arrangement of the light source 20 and detecting means 24 may be reversed, so that the light source 20 is located at the front side of semiconductor wafer 1 and the detector 24 is located at the back side thereof. However the experiments indicate that better contrast can be obtained with an arrangement wherein the light source is located at the back side and the detector is located at the front side as shown in Fig. 1.

In automatic wafer processing for manufacturing gate array integrated circuits, it is necessary to identify each wafer (1) at the beginning of each process step. This is achieved by detecting a bar code pattern (5) provided on the wafer (1). A light source (20) which abundantly provides infrared light is positioned at the back side of the wafer (1) and a detector (24) at the front side thereof. The infrared light from the light source (20) easily penetrates the silicon wafer (1) and is received at the detector without any significant effect of reflection due to deposited layers on the front side of the wafer. The bar code pattern (5) is such as to selectively modify (e.g. selectively block) transmission of infrared light. A first metallization layer (Al-I) is a very suitable layer for use to form a bar code pattern, which can be easily formed in the layer by a laser beam scriber.

## Claims

1. A method for identifying a semiconductor wafer utilizing a bar code pattern formed thereon, said method comprising:

   applying light including infrared light to a first side of the semiconductor wafer;

   receiving infrared light transmitted through said semiconductor wafer, at a second side of said semiconductor wafer; and

   identifying the semi conductor wafer by decoding the received light.

2. A method as claimed in claim 1, wherein the infrared light is applied to the back side of the semi conductor wafer and the transmitted infrared light is received at the front side thereof.

3. A method as claimed in claim 1, wherein the infrared light is applied to the front side of the semi conductor wafer and the transmitted infrared light is received at the back side thereof.

4. A method as claimed in claim 1, 2 or 3, wherein the bar code pattern is formed utilising a metal layer having a low transmission factor for infrared light.

5. A method as claimed in claim 4, wherein the metal layer is of aluminum.

6. A method as claimed in claim 4 or 5, wherein the bar code pattern is formed by scribing and evaporating the metal layer with a laser beam.

7. A method as claimed in any preceding claim, wherein the bar code pattern is formed utilising a metal layer which is deposited as a first metallization layer.

8. A method as claimed in claim 7, wherein a window or windows is or are formed above said bar code pattern area with regard to the or each subsequently formed metal layer in the case of multilevel metallization.

9. A method as claimed in claim 1, 2 or 3, wherein said bar code pattern is formed on the semiconductor wafer by scribing a surface thereof with a laser beam, and a window or windows is or are formed above said bar code pattern area with regard to the or each subsequently formed metal layer.

10. A method for manufacturing semiconductor devices, comprising the following sequence of steps:-
    (a) preparing a plurality of semiconductor wafers;
    (b) performing common bulk processes on the plurality of semiconductor wafers, comprising at least impurity introduction into each semiconductor wafer of the plurality and forming an insulating layer thereon;
    (c) forming a metal layer capable of blocking transmission of infrared light, on each semiconductor wafer of the plurality, in respect of a first region, wherein an electrical element is to be formed, and in respect of second region wherein a characteristic bar code pattern is to be formed;
    (d) from each semiconductor wafer of the plurality, removing selectively said metal layer in said second region, to form such a bar code pattern;
    (e) in respect of each semiconductor wafer of the plurality, applying infrared light to the second region from a first side of the semiconductor wafer and detecting at a second side of the wafer infrared light transmitted through the semiconductor wafer and its bar code pattern and decoding its bar code pattern;
    (f) identifying each of the semiconductor wafers by means of the decoding; and
    (g) from each semiconductor wafer of the plurality, selectively removing said metal layer, whereby a specified metal pattern is formed corresponding to the identification of the wafer.

11. A method as claimed in claim 10, further comprising in respect of each semiconductor wafer of the plurality:-
    forming an insulating layer capable of transmitting infrared light on said metal layer forming a specified pattern in the first region and on the bar code pattern in the second region;
    forming an additional second metal layer on an entire surface of said insulating layer;
    removing said additional second metal layer above the second region;
    applying infrared light to the second region from a first side of said semiconductor wafer and detecting at a second side of the wafer infrared light transmitted through said semiconductor wafer and its bar code pattern and decoding said bar code;
    identifying said semiconductor wafer by means of the decoding; and
    selectively removing said additional second metal layer, whereby a specified pattern of the additional second metal layer is formed corresponding to said identification.

12. A method as claimed in claims 10 or 11, wherein a gate structure for a gate array is formed in said first region and said metal layer having a specified pattern is connected to said electrical element in the first region.

13. A method for manufacturing a semiconductor, as claimed in claim 11, or claim 12 when read as appended to claim 11, wherein said additional second metal layer having a specified pattern is connected to said metal layer of claim 10.

**Revendications**

1. Un procédé pour identifier une tranche de semiconducteur en utilisant une configuration de code-barres qui est formée sur la tranche, ce procédé comprenant les étapes suivantes :
    on applique à un premier côté de la tranche de semiconducteur de la lumière contenant de la lumière infrarouge;
    on reçoit d'un second côté de la tranche de semiconducteur la lumière infrarouge qui est transmise à travers la tranche de semiconducteur; et

on identifie la tranche de semiconducteur en décodant la lumière qui est reçue.

2. Un procédé selon la revendication 1, dans lequel on applique la lumière infrarouge au côté arrière de la tranche de semiconducteur et on reçoit la lumière infrarouge transmise du côté avant de la tranche.

3. Un procédé selon la revendication 1, dans lequel on applique la lumière infrarouge du côté avant de la tranche de semiconducteur et on reçoit la lumière infrarouge transmise du côté arrière de la tranche.

4. Un procédé selon la revendication 1, 2 ou 3, dans lequel on forme la configuration de code-barres en utilisant une couche de métal ayant un faible facteur de transmission pour la lumière infrarouge.

5. Un procédé selon la revendication 4, dans lequel la couche de métal consiste en aluminium.

6. Un procédé selon la revendication 4 ou 5, dans lequel on forme la configuration de code-barres en gravant et en évaporant la couche de métal avec un faisceau laser.

7. Un procédé selon l'une quelconque des revendications précédentes, dans lequel on forme la configuration de code-barres en utilisant une couche de métal qui est déposée à titre de première couche de métallisation.

8. Un procédé selon la revendication 7, dans lequel on forme une ou plusieurs fenêtres au-dessus de la zone de la configuration de code-barres, dans la couche de métal ou dans chaque couche de métal formée successivement, dans le cas d'une métallisation à plusieurs niveaux.

9. Un procédé selon la revendication 1, 2 ou 3, dans lequel on forme la configuration de code-barres sur la tranche de semiconducteur en gravant une surface de la tranche avec un faisceau laser, et on forme une ou plusieurs fenêtres au-dessus de la zone de la configuration de code-barres, dans la couche de métal ou dans chaque couche de métal formée successivement.

10. Un procédé de fabrication de dispositifs à semiconducteurs comprenant la séquence d'étapes suivantes :

(a) on prépare un ensemble de tranches de semiconducteur;

(b) on accomplit sur l'ensemble de tranches de semiconducteur des traitements de base communs, comprenant au moins l'introduction d'impuretés dans chaque tranche de semiconducteur de l'ensemble, et la formation d'une couche isolante sur ces tranches;

(c) on forme une couche de métal capable d'arrêter la transmission de la lumière infrarouge, sur chaque tranche de semiconducteur de l'ensemble, en relation avec une première région dans laquelle un élément électrique doit être formé, et en relation avec une seconde région dans laquelle une configuration de code-barres caractéristique doit être formée;

(d) on enlève sélectivement la couche de métal dans la seconde région, dans chaque tranche de semiconducteur de l'ensemble, pour former une telle configuration de code-barres;

(e) pour chaque tranche de semiconducteur de l'ensemble, on applique de la lumière infrarouge à la seconde région, à partir d'un premier côté de la tranche de semiconducteur, et on détecte sur un second côté de la tranche la lumière infrarouge qui est transmise à travers la tranche de semiconducteur et sa configuration de code-barres, et on décode sa configuration de code-barres;

(f) on identifie chacune des tranches de semiconducteur, au moyen du décodage ; et

(g) on enlève sélectivement la couche de métal dans chaque tranche de semiconducteur de l'ensemble, ce qui a pour effet de former un motif en métal spécifié, en correspondance avec l'identification de la tranche.

11. Un procédé selon la revendication 10, comprenant en outre les étapes suivantes pour chaque tranche de semiconducteur de l'ensemble :

on forme une couche isolante capable de transmettre la lumière infrarouge, sur la couche de métal formant un motif spécifié dans la première région, et sur la configuration de code-barres dans la seconde région;

on forme une seconde couche de métal supplémentaire sur la totalité de la surface de la couche isolante,

on enlève la seconde couche de métal supplémentaire au-dessus de la seconde région;

on applique de la lumière infrarouge à la seconde région, à partir d'un premier côté de la tranche de semiconducteur, et on détecte d'un second côté de la tranche la lumière infrarouge qui est transmise à travers la tranche de semiconducteur et à travers sa configuration de code-barres et on décode ce code-barres;

on identifie la tranche de semiconducteur au moyen du décodage; et

on enlève sélectivement la seconde couche de métal supplémentaire, ce qui a pour effet de former un motif spécifié de la seconde couche de métal, en correspondance avec l'identification.

12. Un procédé selon les revendications 10 ou 11, dans lequel une structure de portes pour un réseau de portes est formée dans la première région, et la couche de métal ayant un motif spécifié est connectée à l'élément électrique dans la première région.

13. Un procédé de fabrication d'un semiconducteur selon la revendication 11, ou selon la revendication 12 lorsqu'elle est rattachée à la revendication 11, dans lequel la seconde couche de métal supplémentaire ayant un motif spécifié est connectée à la couche de métal de la revendication 10.

## Ansprüche

1. Verfahren zum Identifizieren eines Halbleiterwafers unter Verwendung eines darauf geformten Strichcodemusters, welches Verfahren umfaßt:

Aufbringen von Licht, das infrarotes Licht enthält, auf eine erste Seite des Halbleiterwafers;

Empfangen von infrarotem Licht, das durch den genannten Halbleiterwafer transmittiert wurde, auf einer zweiten Seite des genannten Halbleiterwafers, und

Identifizieren des Halbleiterwafers durch Decodieren des empfangenen Lichtes.

2. Verfahren nach Anspruch 1, bei dem das infrarote Licht auf die Rückseite des Halbleiterwafers aufgebracht und das transmittierte infrarote Licht an der Vorderseite desselben empfangen wird.

3. Verfahren nach Anspruch 1, bei dem das infrarote Licht auf die Vorderseite des Halbleiterwafers aufgebracht und das transmittierte infrarote Licht an der Rückseite desselben empfangen wird.

4. Verfahren nach Anspruch 1, 2 oder 3, bei dem das Strichcodemuster unter Verwendung einer Metallschicht gebildet ist, welche einen niedrigen Transmissionsfaktor für infrarotes Licht hat.

5. Verfahren nach Anspruch 4, bei dem die Metallschicht aus Aluminium besteht.

6. Verfahren nach Anspruch 4 oder 5, bei dem das Strichcodemuster durch Ritzen und Verdampfen der Metallschicht mit einem Laserstrahl gebildet wird.

7. Verfahren nach einem der vorhergehenden Ansprüche, bei dem das Strichcodemuster unter Verwendung einer Metallschicht gebildet wird, welche als eine erste Metallisierungsschicht deponiert wird.

8. Verfahren nach Anspruch 7, bei dem im Falle einer Mehrfachpegel-Metallisierung ein oder mehrere Fenster oberhalb des genannten Strichcodemusterbereiches, in Bezug auf die oder jede danach gebildete Metallschicht, gebildet werden.

9. Verfahren nach Anspruch 1, 2 oder 3, bei dem das genannte Strichcodemuster auf dem Halbleiterwafer durch Ritzen einer Oberfläche desselben mit einem Laserstrahl gebildet wird, und ein oder mehrere Fenster oberhalb des genannten Strichcodemusterbereiches in Bezug auf die oder jede nachfolgend gebildete Metallschicht gebildet werden.

10. Verfahren zur Herstellung von Halbleitervorrichtungen, mit der folgenden Schrittfolge:

(a) Präparieren einer Vielzahl von Halbleiterwafern;

(b) Bilden eines gemeinsamen Grundkörperprozesses auf der Vielzahl von Halbleiterwafern, mit wenigstens der Einführung von Verunreinigung in jedes der vielen Halbleiterwafer und Bilden einer isolierenden Schicht darauf:

(c) Bilden einer Metallschicht, die die Transmission von infrarotem Licht blockieren kann, auf jedem der vielen Halbleiterwafer, in Bezug auf einen ersten Bereich, in dem ein elektrisches Element gebildet werden soll, und in Bezug auf einen zweiten Bereich, in dem ein charakteristisches Strichcodemuster geformt werden soll;

(d) selektives Entfernen der genannten Metallschicht in dem genannten zweiten Bereich, von jedem der vielen Halbleiterwafer, um solch ein Strichcodemuster zu bilden,

(e) in Bezug auf jeden der vielen Halbleiterwafer, Aufbringen von infrarotem Licht auf den genannten zweiten Bereich von einer ersten Seite des Halbleiterwafers, und Detektieren des durch den Halbleiterwafer transmittierten infraroten Lichtes und seines Strichcodemusters auf einer zweiten Seite des Wafers und Decodieren seines Strichcodemusters;

(f) Identifizieren jedes Halbleiterwafers durch das Decodieren; und

(g) selektives Entfernen der genannten Metallschicht, von jedem der vielen Halbleiterwafer, wodurch ein spezifiziertes Metallmuster gebildet wird, welches der Identifizierung des Wafers entspricht.

11. Verfahren nach Anspruch 10, ferner mit, in Bezug auf jedes der genannten vielen Halbleiterwafer:-

Bilden einer isolierenden Schicht, die infrarotes Licht auf die genannte Metallschicht transmittieren kann, die ein spezifiziertes Muster in dem ersten Bereich bildet, und auf dem Strichcodemuster in dem zweiten Bereich;

Bilden einer zusätzlichen zweiten Metallschicht auf der gesamten Oberfläche der genannten isolierenden Schicht;

Entfernen der genannten zusätzlichen zweiten Metallschicht oberhalb des zweiten Bereichs;

Aufbringen von infrarotem Licht auf den genannten zweiten Bereich, von einer ersten Seite des genannten Halbleiterwafers, und, auf einer zweiten Seite des Wafers, Detektieren des durch den genannten Halbleiterwafer transmittierten infraroten Lichtes und seines Strichcodemusters und Decodieren des genannten Strichcodes;

Identifizieren des genannten Halbleiterwafers durch Decodierungseinrichtungen; und

selektives Entfernen der genannten zusätzlichen zweiten Metallschicht, wodurch ein spezifiziertes Muster der zusätzlichen zweiten Metallschicht entsprechend der genannten Identifikation gebildet wird.

12. Verfahren nach Anspruch 10 oder 11, bei dem eine Gatestruktur für ein Gatearray in dem genannten ersten Bereich gebildet wird, und die genannte Metallschicht, die ein spezifiziertes Muster hat, mit dem genannten elektrischen Element in dem ersten Bereich verbunden wird.

13. Verfahren zur Herstellung eines Halbleiters nach Anspruch 11, oder nach Anspruch 12 in Verbindung mit Anspruch 11, bei dem die genannte zusätzliche zweite Metallschicht, die ein spezifiziertes Muster hat, mit der genannten Metallschicht von Anspruch 10 verbunden wird.

FIG. 1

FIG. 2

FIG. 3

```
                              ┌─40
            ┌──────────────────────────────┐
            │      Bulk Wafer Processes     │
            └──────────────────────────────┘
                              │            ┌─42
            ┌──────────────────────────────┐
            │      First Metal Layer        │
            │      Deposition (Al-I)        │
            └──────────────────────────────┘
                              │            ┌─44
            ┌──────────────────────────────┐
            │       Bar Code Forming         │
            └──────────────────────────────┘
                              │            ┌─46
            ┌──────────────────────────────┐
            │       I.D. of Bar Code        │
            └──────────────────────────────┘
                              │            ┌─48
            ┌──────────────────────────────┐
            │       Resist Coating          │
            └──────────────────────────────┘
                              │            ┌─49
            ┌──────────────────────────────┐
            │       I.D. of Bar Code        │
            └──────────────────────────────┘
                              │            ┌─50
            ┌──────────────────────────────┐
            │  Photolithography Process     │
            │   for First Metal Layer       │
            └──────────────────────────────┘
                              │            ┌─52
            ┌──────────────────────────────┐
            │       I.D. of Bar Code        │
            └──────────────────────────────┘
                              │            ┌─54
            ┌──────────────────────────────┐
            │         Development           │
            └──────────────────────────────┘
                              │            ┌─55
            ┌──────────────────────────────┐
            │       I.D of Bar Code         │
            └──────────────────────────────┘
```

```
                              ┌─56
            ┌──────────────────────────────┐
            │          Etching              │
            └──────────────────────────────┘
                              │            ┌─58
            ┌──────────────────────────────┐
            │       I.D. of Bar Code        │
            └──────────────────────────────┘
                              │            ┌─60
            ┌──────────────────────────────┐
            │    Interlayer Insulator       │
            │          Growth               │
            └──────────────────────────────┘
                              │            ┌─62
            ┌──────────────────────────────┐
            │       I.D of Bar Code         │
            └──────────────────────────────┘
                              │            ┌─64
            ┌──────────────────────────────┐
            │  Photolithography Process     │
            │        for Via Holes          │
            └──────────────────────────────┘
                              │            ┌─66
            ┌──────────────────────────────┐
            │       I.D of Bar Code         │
            └──────────────────────────────┘
                              │            ┌─70
            ┌──────────────────────────────┐
            │     Second Metal Layer        │
            │     Deposition (Al-II)        │
            └──────────────────────────────┘
                              │            ┌─72
            ┌──────────────────────────────┐
            │       I.D. of Bar Code        │
            └──────────────────────────────┘
                              │            ┌─74
            ┌──────────────────────────────┐
            │       Resist Coating          │
            └──────────────────────────────┘
                              │            ┌─76
            ┌──────────────────────────────┐
            │  Photolithography Process     │
            │    for Second Metal Layer     │
            └──────────────────────────────┘
```

FIG. 4

13

*FIG. 5*

*FIG. 6*

*FIG. 7*

*FIG. 8*

*FIG. 9*

*FIG. 10*

15

98(AI—II)

*FIG. 11*

*FIG. 12*

5

94

98
92
87
111
110

*FIG. 13*

20

~1

24